Europäisches Patentamt

European Patent Office

Office européen des brevets

(11) Veröffentlichungsnummer : **0 123 182**
**B1**

(12) **EUROPÄISCHE PATENTSCHRIFT**

(45) Veröffentlichungstag der Patentschrift :
19.08.87

(51) Int. Cl.⁴ : **H 01 L 21/82**, H 01 L 27/08

(21) Anmeldenummer : 84103822.7

(22) Anmeldetag : 06.04.84

(54) Verfahren zum Herstellen von hochintegrierten komplementären MOS-Feldeffekttransistorschaltungen.

(30) Priorität : 21.04.83 DE 3314450

(43) Veröffentlichungstag der Anmeldung :
31.10.84 Patentblatt 84/44

(45) Bekanntmachung des Hinweises auf die Patenterteilung : 19.08.87 Patentblatt 87/34

(84) Benannte Vertragsstaaten :
CH DE FR GB IT LI SE

(56) Entgegenhaltungen :
EP-A- 0 072 967
DE-A- 2 700 873
DE-A- 2 740 549
DE-A- 2 933 849
FR-A- 2 351 501
US-A- 3 912 559

(73) Patentinhaber : Siemens Aktiengesellschaft Berlin
und München
Wittelsbacherplatz 2
D-8000 München 2 (DE)

(72) Erfinder : Jacobs, Erwin, Dr. rer.nat.
Stieglitzweg 9b
D-8011 Vaterstetten (DE)
Erfinder : Schwabe, Ulrich, Dr. phil.
Plievierpark 14
D-8000 München 83 (DE)

## Beschreibung

Die vorliegende Patentanmeldung betrifft ein Verfahren zum Herstellen von hochintegrierten komplementären MOS-Feldeffekttransistorschaltungen (CMOS-Schaltungen), bei dem für die Aufnahme der n- bzw. p-Kanal-Transistoren der Schaltung im Siliziumsubstrat p- bzw. n-dotierte Wannen erzeugt werden, in welche zur Einstellung der verschiedenen Transistoreinsatzspannungen die entsprechenden Dotierstoffatome durch mehrfache Ionenimplantationen eingebracht werden, wobei die Maskierung für die einzelnen Ionen-Implantationen durch Fotolack- und/oder durch Siliziumoxid- bzw. Siliziumnitrid-Strukturen erfolgt und bei dem die Herstellung der Source/Drain- und Gate-Bereiche sowie die Erzeugung des Zwischen- und Isolationsoxids und der Leiterbahnebene nach bekannten Verfahrensschritten der MOS-Technologie vorgenommen wird.

Moderne CMOS-Prozesse sind Zwei-Wannen-Prozesse, die in ihrem Aufbau entweder einem p- oder n-Wannen-Grundkonzept zuzuordnen sind, das heißt, in einem n- bzw. p-dotierten, großflächigen Siliziumsubstrat befinden sich die p- bzw. n-Wannen als relativ kleinflächige Inseln.

Die Herstellung der Wannen und die Einstellung der verschiedenen Transistoreinsatzspannungen (Dünnoxid- und Feldoxid-Transistoren in n- und p-Kanal-Bereichen) erfolgt durch mehrfache, aufeinander abgestimmte Ionenimplantationen.

In der Durchführung dieser Prozeßschritte liegen die hauptsächlichen Unterschiede und Nachteile der bekannten CMOS-Prozesse. Der Prozeßablauf eines bekannten n-Wannen-CMOS-Prozesses, wie er beispielsweise in einem Aufsatz von T. Ohzone et al. in der US-Zeitschrift IEEE Trans. Electr. Dev., ED-27, N° 9 (1980) auf den Seiten 1789 bis 1795 beschrieben wird, zeigt zum Beispiel folgende erhebliche Nachteile :

1. Für die n-Kanal-Feldimplantation ist eine eigene Maske erforderlich.

2. Das Polysilizium-Gate muß gegen die Bor-Ionenimplantation durch eine Fotomaske abgeschirmt werden.

3. Die Durchführung der beiden Ionenimplantationsschritte in 1. und 2. sind nur unter Anwendung einer aufwendigen Zwei-Stufen-Fotolithographietechnik möglich.

Fotolithographieschritte und zusätzliche Masken verringern jedoch in erheblichem Maße die Wirtschaftlichkeit des Prozesses.

Die Aufgabe, die der vorliegenden Erfindung zugrundeliegt, besteht in der Durchführung eines CMOS-Prozesses mit n-Wannenkonzept, bei dem möglichst wenige maskenaufwendige Prozeßschritte zur Herstellung der gewünschten Schaltung erforderlich sind, bei dem aber trotzdem gewährleistet wird, daß die Funktionsweise der Bauelemente der Schaltung dadurch nicht beeinträchtigt wird. Außerdem sollen die Kurzkanaleigenschaften der n-Kanal-Transistoren verbessert werden.

Diese Aufgabe wird durch ein Verfahren der eingangs genannten Art gelöst, welches erfindungsgemäß durch den Ablauf folgender Verfahrensschritte gekennzeichnet ist :

a) Aufbringen einer ersten aus Siliziumoxid und Siliziumnitrid bestehenden Doppelschicht auf p-dotiertes Siliziumsubstrat,

b) Herstellung der n-Wannen durch eine Phosphor-, Arsen- oder Antimon-Ionenimplantation nach erfolgter Maskierung der übrigen Bereiche mit einer Fotolackschicht und nach Entfernung der Siliziumnitridschicht im n-Wannenbereich,

c) Ablösen der Fotolackmaske,

d) Durchführung eines lokalen Oxidationsprozesses zur Erzeugung eines Maskieroxids für die nachfolgende Bor-Tiefimplantation außerhalb des n-Wannenbereichs und erster Eindiffusionsschritt der Phosphor-, Arsen- oder Antimon-Ionen,

e) Ablösen der Siliziumnitridstrukturen und weiteres Eintreiben der n-Wanne,

f) Durchführung einer ersten Bor-Ionenimplantation,

g) Ganzflächiges Ablösen der Oxidmaskierung,

h) Aufbringen einer zweiten, aus Siliziumoxid und Siliziumnitrid bestehenden Doppelschicht auf die Substratoberfläche und Strukturierung der mit einer Fotolackmaske bedeckten Siliziumnitridschicht so, daß die aktiven Transistorbereiche von der Siliziumnitridschicht bedeckt bleiben,

i) Ablösen der Fotolackmaske,

j) Aufbringen einer weiteren Fotolackschicht über den n-Wannenbereichen,

k) Durchführung einer zweiten Bor-Ionenimplantation zur Erzeugung der n-Kanal-feldimplantierten Bereiche,

l) Ablösen der Fotolackstrukturen,

m) Erzeugen der Feldoxidbereiche mittels lokaler Oxidation unter Verwendung der Siliziumnitridschicht als Maskierung,

n) Entfernen der Siliziumnitridschicht und der darunterliegenden Oxidschicht und Durchführung eines Oxidationsprozesses zur Herstellung des Gateoxids,

o) Durchführung einer dritten ganzflächigen Bor-Ionenimplantation zur Dotierung des n- und p-Kanals, wobei die Implantationsdosis in Abstimmung mit den anderen Implantationen so gewählt wird, daß für den n- und den p-Kanal-Transistor eine möglichst symmetrische Einsatzspannung $|U_T|$ erreicht wird,

p) Abscheidung und Strukturierung von Polysilizium zur Bildung der Gatebereiche,

q) Durchführung einer Arsen- oder Antimon-Ionenimplantation im n-Kanal-Transistorbereich nach Maskierung der n-Wannenbereiche mit Fotolack,

r) Durchführung eines Oxidationsprozesses nach Ablösung der Fotolackmaskierung so, daß die Oxidschicht im n-Wannenbereich die nachfolgende Source/Drain-Implantation der p-Kanal-Transistoren nicht maskiert, im Bereich der Poly-Si-Kante jedoch maskierend wirken kann (S/D pull back),

s) Durchführung einer Fotolacktechnik zur Maskierung des n-Kanal-Transistorbereiches,

t) Durchführung einer vierten Bor-Ionenimplantation zur Erzeugung der Source/Drain-Bereiche der p-Kanal-Transistoren,

u) Entfernung der Fotolackmaskierung und

v) Erzeugung der Isolationsschicht, der Kontaktlochbereiche und der Metall-Leiterbahnebene in bekannter Weise.

Es liegt im Rahmen der Erfindung, daß beim Verfahrensschritt q) anstelle der Arsen-Ionenimplantation eine Phosphor-Ionenimplantation durchgeführt wird. Dabei erfolgt der Verfahrensschritt r) vor dem Verfahrensschritt q.

Außerdem können die Bor-Ionenimplantationen, insbesondere nach Verfahrensschritt f) unter Verwendung von Borfluorid ($BF_2$) durchgeführt werden. Die Energie ist dann ca. 4 x so hoch ; das ermöglicht bei gegebener unterer Grenzenergie der Implantationsmaschinen niedrigere Eindringtiefen.

Das Verfahren nach der Lehre der Erfindung, welches nur acht Masken und sechs Ionenimplantationen erfordert, unterscheidet sich von bisher bekannten n-Wannen-CMOS-Prozessen durch folgende Vorteile :

1. Verbesserung der Kurzkanaleigenschaften der n-Kanal-Transistoren durch Bor-Ionendoppelimplantation des Kanalgebiets (nach Verfahrensschritt f) und o)),

2. Einsparung der Kanal-Ionenimplantationsmaske für die n-Kanal-Transistoren durch eine einzige, für beide Transistortypen gemeinsame Kanalimplantation (nach Verfahrensschritt o)),

3. Abschirmung des Polysilizium-Gates gegen die Bor-Ionen-Implantation durch den maskierenden Reoxidationsschritt (nach Verfahrensschritt r)) und

4. Angleichung der Unterdiffusion bei n- und p-Kanal-Transistoren durch Zurückziehen (pull-back) der Source-Drain-Implantation mittels Polysilizium-Oxidation (nach Verfahrensschritt r).

Zu 1. : Während bei den p-Kanal-Transistoren auch bei kleinen Kanallängen infolge der hohen n-Wannen-Dotierung (Konzentration 3 bis 5 × $10^{15}$ $P^+$ $cm^{-3}$) eine ausreichende Durchbruchsspannungsfestigkeit gewährleistet ist, wird bei den n-Kanal-Transistoren eine zusätzliche Dotierung erforderlich, wenn ein frühzeitiger punch through-Durchbruch bei kleinen Kanallängen vermieden werden soll.

Nach der Lehre der Erfindung wird dies durch eine Bor-Ionen-Tiefimplantation nach Verfahrensschritt f) erreicht, die zusammen mit der Kanalimplantation nach Verfahrensschritt o) eine wirksame Doppelimplantation der aktiven n-Kanal-Bereiche ergibt. Die Tiefimplantation wird erfindungsgemäß durch eine lokale Oxidmaske selbstjustierend zur n-Wanne durchgeführt.

Zu 2. : Da durch die vorhergehende Bor-Ionen-Tiefimplantation (Konzentration $c_B$ = 3 × $10^{15}$ $cm^{-3}$ für eine Eindringtiefe $x_j$ = 0,5 μm) ein frühzeitiger Durchbruch des n-Kanal-Transistors verhindert wird, können durch eine einzige gemeinsame Bor-Ionen-Flachimplantation nach Verfahrensschritt o) die Einsatzspannungen beider n- bzw. p-Kanal-Transistoren gleichzeitig eingestellt werden. Eine Kanal-Ionen-Implantationsmaske ist damit hinfällig.

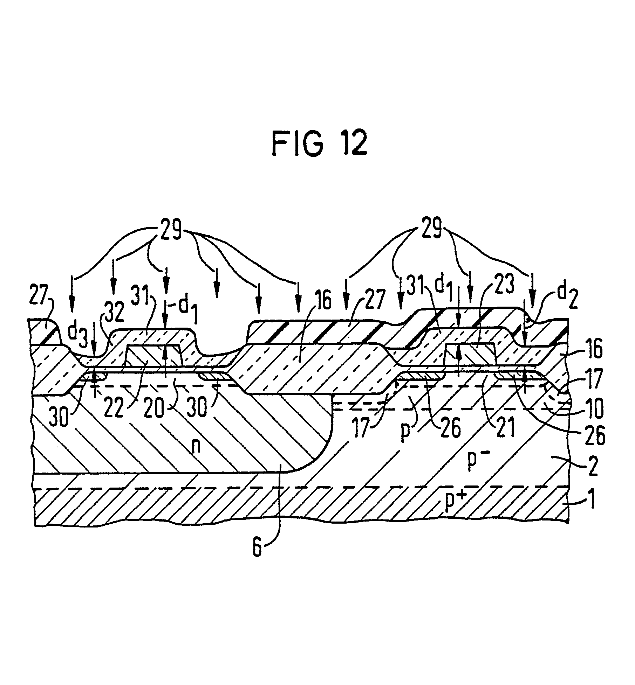

Zu 3. : Infolge der unterschiedlichen Oxidationsraten von $n^+$-dotiertem Silizium (S/D-Gebiete, n-Kanal), $n^-$-dotiertem Silizium (n-Wanne) und von Polysilizium können durch einen Reoxidationsschritt nach Verfahrensschritt r) bzw. vor dem Verfahrensschritt q) verschiedene Oxiddicken eingestellt werden (siehe Figur 12, für Verfahrensschritt r), wenn eine Arsen-Ionenimplantation vorliegt : $d_1$ ~ 130 nm, $d_2$ ~ 120 nm, $d_3$ ~ 65 nm ; wenn eine Phosphor-Ionenimplantation vorliegt : $d_1$ ~ 230 nm, $d_2$ ~ 210 nm, $d_3$ ~ 70 nm). Die Oxiddicke $d_1$ wirkt bei der nachfolgenden Bor-Ionen-S/D-Implantation nach Verfahrensschritt t) als Maskierung des Polysilizium-Gebietes, während $d_3$ dünn genug ist, um die Bor-Ionen-Implantation nach Verfahrensschritt t) nicht abzuschirmen.

Zu 4. : Der beschriebene Reoxidationsschritt gemäß Verfahrensschritt r) dient weiterhin zum Zurückziehen (pull back) der Bor-Ionen S/D-Implantation. Bei den nachfolgenden Temperaturbelastungen wird dadurch die stärkere Ausdiffusion der Bor-dotierten S/D-Gebiete (p-Kanal-Transistoren) im Vergleich zu den $n^+$ ($As^+$, $P^+$, $Sb^+$) -dotierten S/D-Gebieten (n-Kanal-Transistoren) ausgeglichen. Die Unterdiffusion unter die aktiven Gates und somit die parasitären Miller-Kapazitäten werden stark reduziert. Dies trägt wesentlich zu einem symmetrischen $U_T$ (L)-Verhalten (= Kanallängenabhängigkeit der Einsatzspannungen) der Transistoren und zur Erreichung hoher Schaltgeschwindigkeiten bei.

Es liegt im Rahmen der Erfindung, daß bei Verwendung von Metallsiliziden, vorzugsweise von Tantalsilizid, anstelle von Polysilizium als Gatematerial nach Verfahrensschritt p) eine $SiO_2$-Abscheidung durchgeführt wird und daß anschließend durch einen anisotropen Ätzprozeß diese Oxidschicht so abgeätzt wird, daß an den Poly-Si-Kanten eine ausreichend dicke Oxidschicht (Oxide Spacer) stehen bleibt, um einen S/D-pull back-Effekt zu erzielen.

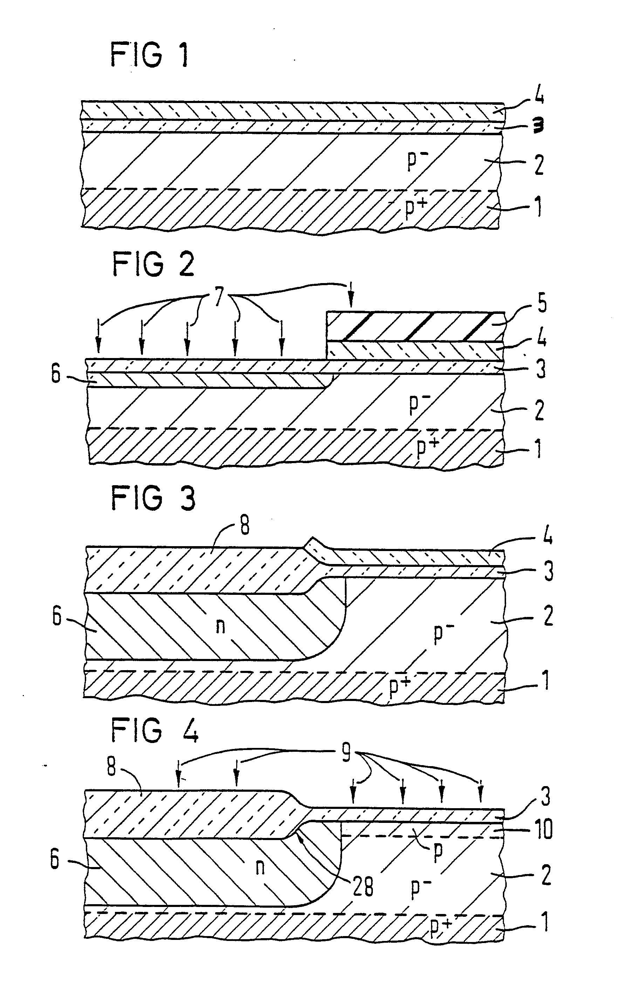

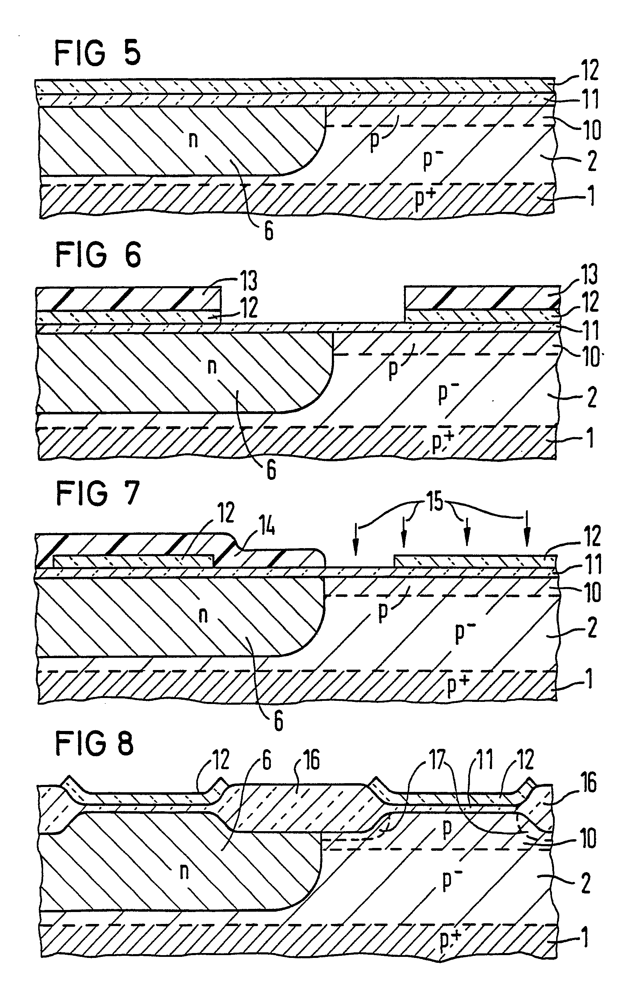

Weitere Ausgestaltungen der Erfindung ergeben sich aus den Unteransprüchen, sowie aus der Beschreibung eines Ausführungsbeispiels anhand der Figuren 1 bis 12, welche im Schnittbild die erfindungswesentlichen Verfahrensschritte darstellen. In allen Figuren gelten für gleiche Teile gleiche Bezugszeichen.

Figur 1 Zu Beginn der Prozeßfolge wird auf ein, mit einer $p^-$-dotierten Epitaxieschicht 2 (6 bis 10 μm Dicke, 20 Ohm · cm) versehenes $p^+$-dotiertes in <100> -Richtung orientiertes Siliziumsubstrat 1 (0,01 bis 0,02 Ohm · cm) eine aus einer $SiO_2$-Schicht 3 (50 nm) und einer Sili-

ziumnitridschicht 4 (140 nm) bestehende Doppelschicht abgeschieden.

Figur 2 Mit Hilfe einer Fotolackstruktur 5 wird die Siliziumnitridschicht 4 strukturiert und die n-Wanne 6 durch eine Phosphorionenimplantation 7 mit einer Dosis und Energie von 2 bis $2,5 \times 10^{12}$ cm$^{-2}$ bzw. 160 keV erzeugt.

Figur 3 Nach Ablösen der Fotolackstruktur (5) wird ein lokaler Oxidationsprozeß zur Erzeugung eines Maskieroxids 8 (500 nm) für die nachfolgende Bor-Tiefimplantation (9) durchgeführt und dabei die Phosphor-Ionen (7) in den n-Wannenbereich 6 eindiffundiert.

Figur 4 Nach Ablösen der Siliziumnitridstruktur (4) wird ein weiterer Eindiffusionsschritt der n-Wanne (drive-in ~ 2 bis 6 μm) und die Bor-Tiefimplantation (siehe Pfeile 9) mit einer Dosis und Energie von 3 bis $7 \times 10^{11}$ cm$^{-2}$ bzw. 60 keV durch die lokale Oxidmaske 8 selbstjustierend zur n-Wanne 6 durchgeführt. Es entsteht die p-dotierte Zone 10. Die mit dem Pfeil 28 gekennzeichnete Oxidkante wird in den folgenden Figuren vernachlässigt.

Figur 5 Nach Entfernung der Oxidmaskierung (8) wird eine weitere, aus Siliziumoxid 11 und Siliziumnitrid 12 bestehende Doppelschicht auf die Substratoberfläche (1, 2, 6, 10) aufgebracht.

Figur 6 Mit einer Fotolackmaske 13 wird die Siliziumnitridschicht 12 so strukturiert, daß sie die aktiven Transistorbereiche im Substrat überdeckt.

Figur 7 Nach Ablösen der Fotolackmaske 13 wird eine weitere Fotolackstruktur 14 zur Maskierung der n-Wanne 6 erzeugt und die n-Kanal-Feldimplantation (siehe Pfeile 15) mit Bor-Ionen bei einer Dosis und Energie von 1 bis $2 \times 10^{13}$ cm$^{-2}$ und 25 keV durchgeführt.

Figur 8 Nach Ablösung der Fotolackstruktur 14 werden dann unter Verwendung der Siliziumnitridschicht 12 als Maskierung die Feldoxidbereiche 16 in einer Schichtdicke von 800 bis 1 000 nm durch lokale Oxidation erzeugt. Dabei entstehen die p-dotierten Zonen 17.

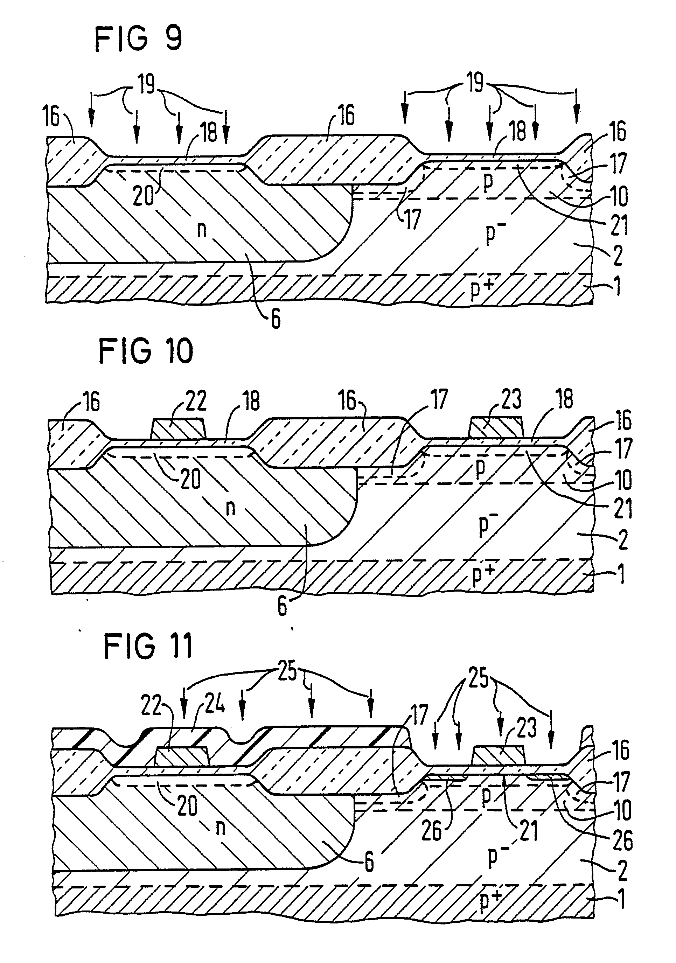

Figur 9 Nach Ablösen der Siliziumnitridschicht 12 und der Siliziumoxidschicht 11 erfolgt eine thermische Oxidation der gesamten Oberfläche, wobei die Dicke der Gateoxidschicht 18 mit 15 bis 50 nm eingestellt wird. Dann erfolgt eine ganzflächige flache Bor-Ionenimplantation (siehe Pfeile 19) zur Dotierung des p- und n-Kanals (20, 21), wobei die Implantationsdosis in Abstimmung mit den anderen Implantationen so gewählt wird, daß für den n- und den p-Kanal eine möglichst symmetrische Einsatzspannung $U_T$ erreicht wird. Im vorliegenden Ausführungsbeispiel wird die Implantationsdosis und Energie auf $4,5 \times 10^{11}$ B$^+$ cm$^{-2}$ bzw. 25 keV eingestellt, was einer Einsatzspannung $|U_T| = ~ 0,8$ V entspricht. Da die Ionenimplantation (19) ganzflächig erfolgt, wird im Gegensatz zu bekannten CMOS-Prozessen keine Maske benötigt.

Figur 10 Es erfolgt nun die Abscheidung der Polysiliziumebene (500 nm) und ihre Strukturierung, wobei die Gateelektroden 22 und 23 gebildet werden.

Figur 11 Mittels einer Fotolackmaske 24 werden die n-Wannenbereiche 6 abgedeckt und durch eine anschließende Arsen-Ionenimplantation (siehe Pfeile 25) mit einer Dosis und Energie von $6 \times 10^{15}$ cm$^{-2}$ bzw. 80 keV die Source/DrainGebiete 26 der n-Kanaltransistoren (21) erzeugt.

Figur 12 Nun wird nach Ablösung der Fotolackmaskierung 24 ein thermischer Oxidationsprozeß (Reoxidationsschicht 31) durchgeführt, bei dem auch die Source/Drain-Bereiche 26 der n-Kanal-Transistoren eingetrieben werden. Außerdem wird der Oxidationsprozeß (Reoxidation) so geführt, daß die Oxidschicht $(d_1)$ über den Polysilizium-Gates 22 und 23 ~ 130 nm, die Oxidschicht $d_2$ über den n$^+$-dotierten Source/Drain-Zonen 26 ~ 120 nm und die Oxidschicht $d_3$ im S/D-Bereich (6) der p-Kanal-Transistoren ~ 65 nm beträgt, also die nachfolgende Source/Drain-Implantation (29) der p-Kanal-Transistoren nicht maskiert. Nach Aufbringen einer Fotolackmaske 27 zur Maskierung des n-Kanal-Transistorbereiches wird nun die ganzflächige Bor-Ionenimplantation (siehe Pfeile 29) zur Erzeugung der Source/Drain-Zonen 30 der p-Kanal-Transistoren in der n-Wanne 6 durchgeführt. Dabei werden Dosis und Energie auf $4 \times 10^{15}$ cm$^{-2}$, 25 keV eingestellt. Die Oxidschicht 32 auf den Flanken des Poly-Si-Gates der p-Kanal-Transistoren dient dabei zur Zurückziehung der Implantation (S/D-pull back). Nach Ablösung der Fotolackmaske 27 entstehen durch Eintreiben der implantierten Boratome die Source/Drain-Bereiche 30 der p-Kanaltransistoren.

Die Erzeugung der Isolationsschicht, der Kontaktlochbereiche und der Metall-Leiterbahnebene erfolgt nach bekannten Verfahrensschritten der CMOS-Technologie und wird nicht dargestellt.

**Patentansprüche**

1. Verfahren zum Herstellen von hochintegrierten komplementären MOS-Feldeffekttransistorschaltungen (CMOS-Schaltungen), bei dem für die Aufnahme der n- bzw. p-Kanal-Transistoren der Schaltung im Siliziumsubstrat (1, 2) p- bzw. n-dotierte Wannen (10, 6) erzeugt werden, in welche zur Einstellung der verschiedenen Transistoreinsatzspannungen die entsprechenden Dotierstoffatome durch mehrfache Ionenimplantationen eingebracht werden, wobei die Maskierung für die einzelnen Ionen-Implantationen durch Fotolack- und/oder durch Siliziumoxid- bzw. Siliziumnitrid-Strukturen erfolgt und bei dem die Herstellung der Source/Drain (26, 30)- und Gate-Bereiche (22, 23) sowie die Erzeugung des Zwischen- und Isolationsoxids und der Leiterbahnebene nach bekannten Verfahrensschritten der MOS-Technologie vorgenommen wird, gekennzeichnet durch den Ablauf folgender Verfahrensschritte :

a) Aufbringen einer ersten aus Siliziumoxid (3) und Siliziumnitrid (4) bestehenden Doppelschicht auf p-dotiertes Siliziumsubstrat (1, 2),

b) Herstellung der n-Wannen (6) durch eine Phosphor-, Arsen- oder Antimon-Ionenimplantation (7) nach erfolgter Maskierung der übrigen Bereiche mit einer Fotolackschicht (5) und nach Entfernung der Siliziumnitridschicht (4) im n-Wannenbereich (6),

c) Ablösen der Fotolackmaske (5),

d) Durchführung eines lokalen Oxidationsprozesses zur Erzeugung eines Maskieroxids (8) für die nachfolgende Bor-Tiefimplantation (9) außerhalb des n-Wannenbereiches (6) und erster Eindiffusionsschritt der Phosphor-, Arsen- oder Antimon-Ionen (7),

e) Ablösen der Siliziumnitridstrukturen (4) und weiteres Eintreiben der n-Wanne (6),

f) Durchführung einer ersten Bor-Ionenimplantation (9),

g) Ganzflächiges Ablösen der Oxidmaskierung (3, 8),

h) Aufbringen einer zweiten, aus Siliziumoxid (11) und Siliziumnitrid (12) bestehenden Doppelschicht auf die Substratoberfläche und Strukturierung der mit einer Fotolackmaske (13) bedeckten Siliziumnitridschicht (12) so, daß die aktiven Transistorbereiche von der Siliziumnitridschicht (12) bedeckt bleiben,

i) Ablösen der Fotolackmaske (13),

j) Aufbringen einer weiteren Fotolackschicht (14) über den n-Wannenbereichen (6),

k) Durchführung einer zweiten Bor-Ionenimplantation (15) zur Erzeugung der n-Kanal-feldimplantierten Bereiche (17),

l) Ablösen der Fotolackstrukturen (14), m) Erzeugen der Feldoxidbereiche (16) mittels lokaler Oxidation unter Verwendung der Siliziumnitridschicht (12) als Maskierung,

n) Entfernen der Siliziumnitridschicht (12) und der darunterliegenden Oxidschicht (11) und Durchführung eines Oxidationsprozesses zur Herstellung des Gateoxids (18),

o) Durchführung einer dritten ganzflächigen Bor-Ionenimplantation (19) zur Dotierung des n- (21) und p-Kanals (20), wobei die Implantationsdosis in Abstimmung mit den anderen Implantationen so gewählt wird, daß für den n- und den p-Kanal-Transistor eine möglichst symmetrische Einsatzspannung $|U_T|$ erreicht wird,

p) Abscheidung und Strukturierung von Polysilizium zur Bildung der Gatebereiche (22, 23),

q) Durchführung einer Arsen- oder Antimon-Ionenimplantation (25) im n-Kanal-Transistorbereich nach Maskierung der n-Wannenbereiche (6) mit Fotolack (24),

r) Durchführung eines Oxidationsprozesses nach Ablösung der Fotolackmaskierung (24) so, daß die Oxidschicht (31) im n-Wannenbereich (6) die nachfolgende Source/ Drain-Implantation (29) der p-Kanal-Transistoren nicht maskiert, im Bereich der Polysiliziumkante jedoch maskierend wirken kann,

s) Durchführung einer Fotolacktechnik zur Maskierung (27) des n-Kanal-Transistorbereiches,

t) Durchführung einer vierten Bor-Ionenimplantation (29) zur Erzeugung der Source/Drain-Bereiche (30) der p-Kanal-Transistoren,

u) Entfernung der Fotolackmaskierung (27) und

v) Erzeugung der Isolationsschicht, der Kontaktlochbereiche und der Metall-Leiterbahnebene in bekannter Weise.

2. Verfahren nach Anspruch 1, dadurch gekennzeichnet, daß beim Verfahrensschritt q) eine Phosphor-Ionenimplantation durchgeführt wird und der Verfahrensschritt r) vor dem Verfahrensschritt q) erfolgt.

3. Verfahren nach Anspruch 1 und 2, dadurch gekennzeichnet, daß als Substrat (1) p-dotiertes in 100 -Richtung orientiertes Silizium von 20 Ohm · cm oder eine solche epitaxiale Schicht (2) im Bereich von 6 bis 10 µm Dicke auf einem $p^+$-dotierten Siliziumsubstrat (1) von 0,01 bis 0,02 Ohm · cm verwendet wird.

4. Verfahren nach Anspruch 1 bis 3, dadurch gekennzeichnet, daß eine erste Doppelschicht (3, 4) verwendet wird, die aus einer 40 bis 60 nm dicken $SiO_2$-Schicht (3) und einer 120 bis 160 nm dicken Siliziumnitridschicht (4) besteht.

5. Verfahren nach Anspruch 1 bis 4, dadurch gekennzeichnet, daß beim Verfahrensschritt b) die Dosis und Energie der Phosphor-, Arsen- oder Antimon-Ionenimplantation (7) auf einen Bereich von 2 bis 2,5 × $10^{12}$ cm$^{-2}$ und 150 bis 180 keV eingestellt wird.

6. Verfahren nach Anspruch 1 bis 5, dadurch gekennzeichnet, daß die Dosis und Energie für die erste Bor-Ionenimplantation (9) nach Verfahrensschritt f) auf einen Bereich von 4 bis 6 × $10^{11}$ cm$^{-2}$ und 40 bis 60 keV, für die zweite Bor-Ionenimplantation (15) nach Verfahrensschritt k) auf einen Bereich von 1 bis 1,5 × $10^{13}$ cm$^{-2}$ und 20 bis 25 keV, für die dritte ganzflächige Bor-Ionenimplantation (19) nach Verfahrensschritt o) auf 4 bis 6 × $10^{11}$ cm$^{-2}$ und 20 bis 25 keV und für die vierte Bor-Ionenimplantation (29) nach Verfahrensschritt t) auf 4 bis 5 × $10^{13}$ cm$^{-2}$ und 10 bis 25 keV eingestellt wird.

7. Verfahren nach Anspruch 6, dadurch gekennzeichnet, daß die Bor-Implantation insbesondere nach Verfahrensschritt t) mit Borfluorid ($BF_2$) durchgeführt wird.

8. Verfahren nach Anspruch 1 bis 7, dadurch gekennzeichnet, daß die Dosis und Energie für die Arsen-, Phosphor- oder Antimon-Ionenimplantation (25) nach Verfahrensschritt q) auf einen Bereich von 5,5 bis 6,5 × $10^{15}$ cm$^{-2}$ und 30 bis 80 keV eingestellt wird.

9. Verfahren nach Anspruch 1 bis 8, dadurch gekennzeichnet, daß der Oxidationsprozeß (31) nach Verfahrensschritt r) so geführt wird, daß die Oxidschichtdicke $d_1$ über der aus Polysilizium bestehenden Gate-Elektrode (22, 23) 130 nm, die Oxidschichtdicke $d_2$ über dem n-Kanalbereich (21, 26) 120 nm und die Oxidschichtdicke (20, 30) $d_3$ über dem p-Kanalbereich 65 nm beträgt.

10. Verfahren nach Anspruch 1 bis 8, dadurch gekennzeichnet, daß bei Verwendung von Metallsilizid anstelle von Polysilizium (22, 23) nach

Verfahrensschritt p) eine SiO₂-Abscheidung durchgeführt wird und daß anschließend ein anisotroper Ätzprozeß so durchgeführt wird, daß diese Oxidschicht so abgeätzt wird, daß an den Gate-Elektrodenkanten eine ausreichend dicke Oxidschicht stehen bleibt, um einen Source/Drain-Zurückzieh-Effekt zu erreichen.

11. Verfahren nach Anspruch 10, dadurch gekennzeichnet, daß als Metallsilizid Tantalsilizid (TaSi₂) verwendet wird.

## Claims

1. A process for the production of highly integrated, complementary MOS-field effect transistor circuits (CMOS-circuits), wherein, to accommodate the n- and p-channel transistors of the circuit, p- and n-doped troughs (10, 6) are produced in the silicon substrate (1, 2), into which troughs, in order to set the various transistor threshold voltages, the corresponding dopant atoms are introduced by a plurality of ion implantation steps, where the masking for the individual ion implantation steps is carried out by means of photo-resist structures and/or silicon oxide and silicon nitride structures, and where the production of the source/drain zones (26, 30) and the gate zones (22, 30), as well as the production of the intermediate oxide and the insulating oxide and of the conductor path level is carried out in accordance with known process steps of MOS-technology, characterised by the sequence of the following process steps :

a) application of a first double layer consisting of silicon oxide (3) and silicon nitride (4), to a p-doped silicon substrate (1, 2),

b) production of the n-troughs (6) by phosphorus, arsenic or antimony ion implantation (7) after the masking of the other regions with a photo-resist layer (5) and after the removal of the silicon nitride layer (4) in the n-trough region (6),

c) removal of the photo-resist mask (5),

d) carrying out of a local oxidation process in order to produce a masking oxide (8) for the subsequent deep implantation (9) of boron outside the n-trough region (6) and of a first diffusing-in step for diffusing-in the phosphorus, arsenic, or antimony ions (7),

e) removal of the silicon nitride structures (4) and further driving-in of the n-trough (6),

f) carrying out of a first boron ion implantation step (9),

g) removal of the oxide mask (3, 8) from the entire surface,

h) application of a second double layer consisting of silicon oxide (11) and silicon nitride (12), to the substrate surface and structuring of the silicon nitride layer (12) covered with a photo-resist mask (13), in such manner that the active transistor regions remain covered by the silicon nitride layer (12),

i) removal of the photo-resist mask (13),

j) application of a further photo-resist layer (14) above the n-trough regions (6),

k) carrying out of a second boron ion implantation step (15) to produce the n-channel-field-implanted regions (17),

l) removal of the photo-resist structures (14), m) formation of the field oxide regions (16) by local oxidation using the silicon nitride layer (12) as mask,

n) removal of the silicon nitride layer (12) and of the underlying oxide layer (11) and carrying out of an oxidation process to produce the gate oxide (18),

o) carrying out of a third boron ion implantation step (19) into the entire surface in order to dope the n-channel (21) and the p-channel (20), the implantation dose being selected, in conformity with the other implantation steps, to be such that for the n-channel transistor and the p-channel transistor, as symmetrical as possible a threshold voltage U_T is obtained,

p) deposition and structuring of polysilicon to form the gate zones (22, 23),

q) carrying out of an arsenic or antimony ion implantation step (25) in the n-channel transistor region after the masking of the n-trough regions (6) with photo-resist (24),

r) carrying out of an oxidation process, after the removal of the photo-resist mask (24), in such manner that the oxide layer (31) in the n-trough region (6) does not mask the subsequent source/drain implantation (29) for the p-channel transistors, but can act as a mask in the region of the polysilicon edge

s) carrying out of a photo-resist step in order to mask (27) the n-channel transistor region,

t) carrying out of a fourth boron ion implantation step (29) to produce the source/drain zones (30) of the p-channel transistors,

u) removal of the photo-resist mask (27), and

v) formation of the insulating layer, of the contact hole regions and of the metal conductor path level, in known manner.

2. A process as claimed in Claim 1, characterised in that in process step q), a phosphorus ion implantation step is carried out and process step r) is carried out before process step q).

3. A process as claimed in Claim 1 and 2, characterised in that as the substrate (1), there is used p-doped silicon of 20 Ohm · cm, orientated in the 100-direction, or of such an epitaxial layer (2) having a thickness in the range of 6 to 10 μm, on a p⁺-doped silicon substrate (1) of 0.01 to 0.02 Ohm · cm.

4. A process as claimed in Claim 1 to 3, characterised in that a first double layer (3, 4) is used which consists of a 40 to 60 nm thick SiO₂-layer (3) and a 120 to 160 nm thick silicon nitride layer (4).

5. A process as claimed in Claim 1 to 4, characterised in that, in process step b), the dose and energy of the phosphorus, arsenic or antimony ion implantation (7) are set in ranges of from 2 to 2.5 × 10¹² cm⁻² and 150 to 180 keV respectively.

6. A process as claimed in Claim 1 to 5, characterised in that the dose and energy for the first boron ion implantation (9) of process step f) are set in ranges of from 4 to 6 × 10¹¹ cm⁻² and 40 to 60 keV respectively, for the second boron ion implantation (15) of process step k) in ranges of from 1 to 1.5 × 10¹³ cm⁻² and 20 to 25 keV respectively, for the third full-surface boron ion implantation (9) of process step o) in ranges of from 4 to 6 × 10¹¹ cm⁻² and 20 to 25 keV respectively, and for the fourth boron ion implantation (29) of process step t) in ranges of from 4 to 5 × 10¹³ cm⁻² and 10 to 25 keV respectively.

7. A process as claimed in Claim 6, characterised in that the boron implantation, particularly but not exclusively that of process step t), is carried out using boron fluoride (BF₂).

8. A process as claimed in Claim 1 to 7, characterised in that the dose and energy for the arsenic, phosphorus or antimony ion implantation (25) of process step q) are set at ranges of from 5.5 to 6.5 × 10¹⁵ cm⁻² and 30 to 80 keV respectively.

9. A process as claimed in Claim 1 to 8, characterised in that the oxidation process (31) of process step r) is carried out in such manner that the oxide layer thickness d₁ above the polysilicon gate electrode (22, 23) is 130 nm, the oxide layer thickness d₂ above the n-channel zone (21, 26) is 120 nm, and the oxide layer thickness d₃ above the p-chamel zone (20, 30) is 65 nm.

10. A process as claimed in Claim 1 to 8, characterised in that when metal silicide is used in place of polysilicon (22, 23) in process step p), an SiO₂-deposition is carried out, and that thereafter an anisotropic etching process is carried out in such manner that this oxide layer is etched away so that at the gate electrode edges an oxide layer remains which is of adequate thickness to achieve a source/drain pull-back effect.

11. A process as claimed in Claim 10, characterised in that tantalum silicide (TaSi₂) is used as the metal silicide.


## Revendications

1. Procédé pour fabriquer des circuits à transistors MOS à effet de champ complémentaires à haute densité d'intégration (circuits MOS), selon lequel pour le montage des transistors à canal n ou p du circuit, on aménage dans le substrat en silicium (1, 2), des cuvettes (10, 6) dopées du type p ou du type n et dans lesquelles, pour régler les différentes tensions de déclenchement des transistors, on introduit les atomes correspondants de substance dopante grâce à des implantations ioniques multiples, auquel cas le masquage pour les différentes implantations ioniques est réalisé au moyen de structures formées par une laque photosensible et/ou au moyen de structures formées par de l'oxyde de silicium ou du nitrure de silicium, et selon lequel la fabrication des régions de source/drain (26, 30) et des régions de grille (22, 23) ainsi que la production de l'oxyde intermédiaire et de l'oxyde isolant et du plan des voies conductrices sont exécutées selon des phases opératoires connues de la technologie MOS, caractérisé par l'exécution des phases opératoires suivantes :

a) dépôt d'une première couche double constituée par de l'oxyde de silicium (3) et du nitrure de silicium (4), sur un substrat en silicium (1, 2) dopé du type p,

b) fabrication des cuvettes de type (6) au moyen d'une implantation de phosphore, d'arsenic ou d'antimoine (7) après exécution du masquage des autres zones par une couche de laque photosensible (9) et après élimination de la couche de silicium (4) dans la région (6) de la cuvette de type n,

c) élimination du masque (5) formé de la laque photosensible,

d) mise en œuvre d'un processus local d'oxydation pour la production d'un oxyde de masquage (8) pour l'implantation profonde ultérieure de bore (9) en dehors de la zone (6) en forme de cuvette de type n et de la première phase de pénétration par diffusion des ions de phosphore, d'arsenic ou d'antimoine (7),

e) élimination des structures de nitrure de silicium (4) et enfoncement supplémentaire de la cuvette (6) de type n,

f) mise en œuvre d'une première implantation d'ions de bore (9),

g) élimination du masque d'oxyde (3, 8) sur toute la surface,

h) dépôt d'une seconde couche double constituée par de l'oxyde de silicium (11) et du nitrure de silicium (12) sur la surface du substrat et structuration de la couche de nitrure de silicium (12) recouverte par un masque formé d'une laque photosensible (13), de sorte que les régions actives des transistors restent recouvertes par la couche de nitrure de silicium (12),

i) élimination du masque formé de laque photosensible (13),

j) dépôt d'une autre couche de laque photosensible (14) sur les régions en forme de cuvettes (6) de type n,

k) mise en œuvre d'une seconde implantation d'ions de bore (15) pour la production des zones (17) qui ont subi une implantation de champ pour un canal de type n,

l) enlèvement des structures formées de la laque photosensible (14),

m) obtention des zones d'oxyde de champ (16) à l'aide d'une oxydation locale moyennant l'utilisation de la couche de nitrure de silicium (12) en tant que masque,

n) élimination de la couche de nitrure de silicium (12) et de la couche d'oxyde sous-jacente (11) et mise en œuvre d'un processus d'oxydation pour fabriquer l'oxyde de grille (18),

o) mise en œuvre d'une troisième implantation d'ions de bore (19) sur l'ensemble de la surface, de manière à doper le canal (21) de type n et le canal (20) de type p, la dose d'implantation étant choisie de manière à coïncider avec les autres implantations afin d'obtenir pour le transistor à canal de type n et pour le transistor à canal de type p une tension de déclenchement autant que possible symétrique $|U_T|$,

p) dépôt de polysilicium et structuration de ce dernier pour la formation des zones de grille (22, 23),

q) mise en œuvre d'une implantation d'ions d'arsenic ou d'antimoine (25) dans la région du transistor à canal de type n après masquage des zones (6) en forme de cuvettes de type n avec une laque photosensible (24),

r) mise en œuvre d'un processus d'oxydation après élimination du masque formé de la laque photosensible (24) de manière que la couche d'oxyde (31) ne réalise pas, dans la région (6) de la cuvette de type n, un masquage pour l'implantation ultérieure (29) de la source/du drain des transistors à canal de type p, mais puisse avoir un effet de masquage dans la zone du bore du polysilicium,

s) mise en œuvre d'une technique utilisant une laque photosensible pour réaliser le masquage (27) de la zone du transistor à canal de type n,

t) mise en œuvre d'une quatrième implantation d'ions de bore (29) pour la production des zones de source/drain (30) des transistors à canal de type p,

u) élimination du masque de laque photosensible (27), et

v) réalisation, de façon connue, de la couche isolante, des zones des trous de contact et du plan des voies conductrices métalliques.

2. Procédé suivant la revendication 1, caractérisé par le fait que, dans le cas de la phase opératoire q), on réalise une implantation d'ions de phosphore et que la phase opératoire r) est mise en œuvre avant la phase opératoire q).

3. Procédé suivant les revendications 1 et 2, caractérisé par le fait qu'on utilise comme substrat (1) du silicium dopé du type p possédant l'orientation 100 et de 20 ohms · cm ou bien une telle couche épitaxiale (2) dans une gamme d'épaisseurs de 6 à 10 µm sur un substrat en silicium (1) dopé de type p, avec entre 0,01 et 0,02 ohm · cm.

4. Procédé suivant les revendications 1 à 3, caractérisé par le fait qu'on utilise une première couche double (3, 4) qui est constituée par une couche (3) de $SiO_2$ possédant une épaisseur comprise entre 40 et 60 nm et une couche de nitrure de silicium (4) possédant une épaisseur comprise entre 120 et 160 nm.

5. Procédé suivant les revendications 1 à 4, caractérisé par le fait que dans le cas de la phase opératoire b), la dose et l'énergie de l'implantation (7) d'ions de phosphore, d'arsenic ou d'antimoine sont réglées dans des gammes comprises entre 2 et $2,5 \times 10^{12}$ $cm^{-2}$ et entre 150 et 180 keV.

6. Procédé suivant les revendications 1 à 5, caractérisé par le fait que la dose et l'énergie pour la première implantation d'ions de bore (9) conformément à la phase opératoire f) sont réglées dans des gammes comprises entre 4 et $6 \times 10^{11}$ $cm^{-2}$ et 40 et 60 keV, que la dose et l'énergie pour la seconde implantation d'ions de bore (15) conformément à la phase opératoire k) sont réglées dans des gammes comprises entre 1 et $1,5 \times 10^{13}$ $cm^{-2}$ et entre 20 et 25 keV, que la dose et l'énergie pour la troisième implantation d'ions de bore (19) sur toute la surface, conformément à la phase opératoire e) sont réglées dans des gammes comprises entre 4 et $6 \times 10^{11}$ $cm^{-2}$ et entre 20 et 25 keV et que la dose et l'énergie pour la quatrième implantation d'ions de bore (29) conformément à la phase opératoire t) sont réglées entre 4 et $5 \times 10^{13}$ $cm^{-2}$ et entre 10 et 25 keV.

7. Procédé suivant la revendication 6, caractérisé par le fait que l'implantation de bore est realisée notamment, conformément à la phase opératoire t), avec du fluorure de bore ($BF_2$).

8. Procédé suivant les revendications 1 à 7, caractérisé par le fait que la dose et l'énergie pour l'implantation (25) d'ions d'arsenic, de phosphore ou d'antimoine conformément à la phase opératoire q) sont réglées dans des gammes comprises entre 5,5 et $6,5 \times 10^{15}$ $cm^{-2}$ et entre 30 et 80 keV.

9. Procédé suivant les revendications 1 à 8, caractérisé par le fait que le processus d'oxydation (31) réalisé conformément à la phase opératoire r) est réalisé de telle sorte que l'épaisseur ($d_1$) de la couche d'oxyde au-dessus de l'électrode de grille (22, 23) constituée par du polysilicium est égale à 130 nm, que l'épaisseur ($d_2$) de la couche d'oxyde au-dessus de la région (21, 26) du canal de type n est égale à 120 nm et que l'épaisseur $d_3$ de la couche d'oxyde (20, 23) au-dessus de la région du canal de type p est égale à 65 nm.

10. Procédé suivant les revendications 1 à 8, caractérisé par le fait que dans le cas d'utilisation d'un siliciure métallique à la place du polysilicium (22, 23) conformément à la phase opératoire p, on réalise un dépôt de $SiO_2$ et qu'ensuite on met en œuvre un processus de corrosion anisotrope de manière que cette couche d'oxyde soit éliminée par décapage de telle manière qu'il subsiste une couche suffisamment épaisse d'oxyde au niveau des bords des électrodes de grille pour obtenir un effet de retrait de la source/du drain.

11. Procédé suivant la revendication 10, caractérisé par le fait qu'on utilise, comme siliciure métallique, du siliciure de tantale ($TaSi_2$).

## FIG 1

4
3
p⁻  2
p⁺  1

## FIG 2

7
5
4
6  3
p⁻  2
p⁺  1

## FIG 3

8
4
3
6
n
2
p⁻
p⁺  1

## FIG 4

9
8
3
10
p
6
n
2
28  p⁻
p⁺  1

## FIG 5

## FIG 6

## FIG 7

## FIG 8

FIG 9

FIG 10

FIG 11

## FIG 12